(19) Europäisches Patentamt
European Patent Office
Office européen des brevets

(11) Veröffentlichungsnummer: **0 131 780**
**B1**

(12) **EUROPÄISCHE PATENTSCHRIFT**

(45) Veröffentlichungstag der Patentschrift: **05.11.86**

(51) Int. Cl.[4]: **G 03 F 7/08**, C 08 G 61/00, C 08 L 65/00

(21) Anmeldenummer: **84107074.1**

(22) Anmeldetag: **20.06.84**

(54) **Lichtempfindliches Gemisch und daraus hergestelltes Kopiermaterial.**

(30) Priorität: **29.06.83 DE 3323343**

(43) Veröffentlichungstag der Anmeldung: **23.01.85 Patentblatt 85/4**

(45) Bekanntmachung des Hinweises auf die Patenterteilung: **05.11.86 Patentblatt 86/45**

(84) Benannte Vertragsstaaten: **AT BE CH DE FR GB IT LI NL SE**

(56) Entgegenhaltungen: **GB-A-1 150 203**

(73) Patentinhaber: **HOECHST AKTIENGESELLSCHAFT, Postfach 80 03 20, D-6230 Frankfurt am Main 80 (DE)**

(72) Erfinder: **Stahlhofen, Paul, Dr., Leibnizstrasse 18b, D-6200 Wiesbaden (DE)**

**EP 0 131 780 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein lichtempfindliches Gemisch aus einer lichtempfindlichen Verbindung oder einer lichtempfindlichen Kombination von Verbindungen, die bei Belichtung ihre Löslichkeit in einer wäßrig-alkalischen Lösung ändert, und einem Bindemittel sowie ein lichtempfindliches Kopiermaterial aus einem Schichtträger und einer lichtempfindlichen Schicht, die aus dem angegebenen Gemisch besteht.

Gemische der genannten Gattung, die als lichtempfindliche Verbindungen positiv arbeitende o-Chinondiazide enthalten und bevorzugt zur Herstellung von Druckplatten verwendet werden, sind z. B. aus der DE-PS 11 95 166 (= US-PS 3 201 239) bekannt. Diese bekannten Gemische enthalten als Bindemittel Phenol- oder Kresol-Formaldehyd-Novolake.

In den EP-A 21 718 und 54 258 werden als Bindemittel für solche Gemische Novolake beschrieben, die durch Umsetzung von substituierten Resorcin-Derivaten mit Aldehyden oder Ketonen hergestellt worden sind.

Flachdruckformen, die aus lichtempfindlichen Flachdruckplatten auf Basis solcher Gemische hergestellt worden sind, zeichnen sich durch hohe Druckauflagen aus. Die Druckschablone solcher Druckformen zeigt jedoch eine gewisse Empfindlichkeit gegenüber Alkohol enthaltenden Feuchtwässern, wie sie in neuerer Zeit häufig verwendet werden. Das hat zur Folge, daß die Druckschablone angegriffen und die Druckauflage herabgesetzt wird. Auch die Resistenz gegenüber wäßrig-alkalischen Entwicklerlösungen und Benzinlösungsmitteln, wie sie während der Kopierarbeiten oder an Druckmaschinen verwendet werden, ist in manchen Fällen nicht ausreichend.

Die Druckauflage und die Resistenz gegenüber Chemikalien von solchen Druckschablonen kann zwar durch Einbrennen bei Temperaturen oberhalb 200°C weiter erhöht werden, doch erfordert dieser Arbeitsschritt wegen der an den bildfreien Stellen auftretenden Einbrennrückstände aus der Schicht in jedem Fall noch eine Vor- oder eine Nachbehandlung der Druckform und damit einen bestimmten Arbeitsaufwand.

Von Nachteil ist ferner die relativ hohe Sprödigkeit der aus Phenolen und Aldehyden bzw. Ketonen hergestellten Novolake, was sich besonders bei der Verarbeitung relativ dicker Kopierschichten, beispielsweise Photoresistschichten, nachteilig auswirkt.

Aufgabe der Erfindung war es, ein lichtempfindliches Gemisch, besonders für die Herstellung von Flachdruckplatten, zur Verfügung zu stellen, das flexiblere Kopierschichten ergibt und das sich einbrennen läßt, ohne daß eine Vor- oder Nachbehandlung der Druckform erforderlich ist.

Erfindungsgemäß wird ein lichtempfindliches Gemisch vorgeschlagen, das bei Belichtung seine Löslichkeit in einer wäßrig-alkalischen Lösung ändert und das eine lichtempfindliche Verbindung oder eine lichtempfindliche Kombination von Verbindungen und ein wasserunlösliches, in wäßrig-alkalischen Lösungen lösliches Bindemittel enthält.

Das erfindungsgemäße Gemisch ist dadurch gekennzeichnet, daß das Bindemittel ein Polykondensationsprodukt aus einem Phenol der allgemeinen Formel

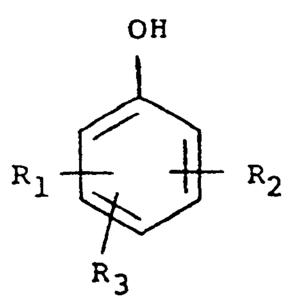

worin

$R_1$ ein Wasserstoffatom, eine Alkyl- oder Hydroxygruppe,

$R_2$ ein Wasserstoffatom, eine Alkyl-, Hydroxy- oder Acetylgruppe und

$R_3$ ein Wasserstoff- oder Halogenatom, eine Alkyl-, Alkoxy-, Carboxyl- oder Carbonsäureestergruppe ist,

und einer Verbindung der allgemeinen Formel

$ROCH_2 - X - CH_2OR$

ist, worin

R ein Wasserstoffatom, ein Methyl-, Ethyl- oder Acetylrest und

X eine Phenylengruppe oder eine zweiwertige aromatische Gruppe ist, die aus zwei durch eine Einfachbindung, eine Ether-, Sulfid-, Sulfon- oder Alkylengruppe verbundenen Phenylengruppen besteht, und gegebenenfalls substituiert sein kann.

Phenole mit mehr als zwei aktivierbaren H-Atomen führen leicht zu Vernetzungen, wobei eine Phenolkomponente gegebenenfalls auch an mehr als zwei $CH_2$-X-$CH_2$-Glieder gebunden sein kann. Aus diesem Grunde werden von den einwertigen Phenolen solche bevorzugt, in denen mindestens eine o- oder die p-Stellung besetzt ist. Mehrwertige Phenole sollten nicht mehr als zwei freie aktivierte Kernpositionen aufweisen.

Geeignete Phenole für die Synthese der erfindungsgemäßen Bindemittel sind zum Beispiel: 4-t-Butyl-phenol,

4-Methyl-phenol, 4-Hydroxy-benzoesäure, 3,4-Dimethyl-phenol, 2-Methyl-resorcin, 2-Ethyl-resorcin, 2-Hexylresorcin, 2-Methyl-5-chlor-resorcin, 2,5-Dimethyl-resorcin, 2,5-Diethyl-resorcin, 4-Methyl-resorcin, 4-Hexylresorcin, 4-Acetyl-resorcin, 5-Methyl-pyrogallol, 5-t-Butyl-pyrogallol, 2,4-Dihydroxy-benzoesäure, 2,4-Dihydroxy-benzoesäuremethylester, 2,4-Dihydroxy-benzoesäure-ethylester, 3,4,5-Trihydroxy-benzoesäure, 3,4,5-Tri-hydroxy-benzoesäuremethylester, 3,4,5-Trihydroxy-benzoesäureethylester, 3,4,5-Trihydroxy-benzoesäurepropylester.

Verbindungen der Formel $ROCH_2$-X-$CH_2OR$ sind bekannt und z. B. in der US-A 3 849 392 als Kondensationspartner für aromatische Diazoniumsalze beschrieben. Dort werden zahlreiche Verbindungen beschrieben, die sich auch als Kondensationspartner im Rahmen der vorliegenden Erfindung eignen. Verbindungen, in denen R eine Methylgruppe ist, und solche, in denen X der Rest eines gegebenenfalls substituierten Diphenylethers, Diphenylsulfids, Diphenyls, Diphenylmethans oder Diphenylsulfons ist, werden besonders bevorzugt. Die freien Valenzen der Arylengruppen X stehen bevorzugt in 1,4- bzw. in 4,4'-Stellung. Wenn X der Rest eines Diphenylalkans ist, hat die Alkangruppe 1 bis 6, bevorzugt 1 bis 3 Kohlenstoffatome.

Beispiele für geeignete Verbindungen der Formel $ROCH_2$-X-$CH_2OR$ sind:
Bis-(methoxymethyl)-diphenylether,
Bis-(methoxymethyl)-benzol,
Bis-(hydroxymethyl)-benzol,
Bis-(methoxymethyl)-diphenylsulfid,
Bis-(methoxymethyl)-diphenyl,
Bis-(acetoxymethyl)-diphenylmethan,
Bis-(hydroxymethyl)-diphenylsulfon,
besonders die entsprechenden 4,4'-Isomeren.

Die Kondensation zur Herstellung der erfindungsgemäßen Bindemittel wird in Gegenwart eines stark sauren Kondensationsmittels durchgeführt. Geeignete Kondensationsmittel sind zum Beispiel Methansulfonsäure (90 - 99 %), konzentrierte Salzsäure, konz. Sösungsmittel bevorzugt Xylol, Dioxan, Toluol, 2-Methoxy-ethylacetat oder Ethanol verwendet.

Der für die Herstellung der Kondensationsprodukte bevorzugte Temperaturbereich erstreckt sich von +10 bis 150°C.

Die Kondensationen verlaufen überraschend glatt und in vielen Fällen bereits unter sehr milden Bedingungen praktisch quantitativ. Es ist anzunehmen, daß bei der Durchführung der Kondensation die Bis-(methoxymethyl)-Verbindungen bevorzugt vollständig oder teilweise unter intermolekularer Abspaltung von Methanol mit der phenolischen Komponente reagieren. Bei einem Überangebot an z. B. 4,4'-Bis-(methoxymethyl)-diphenylether kann letzterer auch mit sich selbst zu Kondensationsprodukten reagieren.

Prinzipiell ist es möglich, auch Mischkondensate beliebiger Zusammensetzung herzustellen, z. B. Mischkondensate, die unterschiedliche Phenolkomponenten enthalten.

Die Löslichkeit und die mittleren Molekulargewichte der Kondensationsprodukte können je nach Wahl der Kondensationsteilnehmer und Versuchsbedingungen stark variieren. Bei Phenolkomponenten mit mehr als zwei aktivierbaren H-Atomen treten leicht Vernetzungen ein, die die Löslichkeit und die Eigenschaften der fertigen Kondensationsprodukte sehr beeinträchtigen. So reagieren die nicht substituierten Phenole - z. B. Pyrogallol, Resorcin und Phenol - mit den oben angeführten 4,4'-Bis-(methoxymethyl)-Verbindungen in Gegenwart saurer Kondensationsmittel sehr heftig unter Bildung von kunststoffartigen Verbindungen, die wegen ihrer oft sehr geringen Löslichkeit als Bindemittel gemäß der Erfindung normalerweise nicht geeignet sind. Darüber hinaus haben die Reaktionsbedingungen, wie Temperatur und Reaktionszeit, insbesondere die Art und Menge des verwendeten sauren Kondensationsmittels, großen Einfluß auf die Löslichkeit der entstehenden Kondensationsprodukte. Bei Anwendung von sehr geringen Mengen an Kondensationsmittel erhält man normalerweise Kondensationsprodukte von relativ niedrigem Molekulargewicht und oftmals weicher Konsistenz. Kondensationsprodukte mit Molekulargewichten zwischen 600 und 10 000 haben sich zur Herstellung guter Kopiermaterialien als besonders geeignet erwiesen.

Die Kondensationsprodukte gemäß der Erfindung haben gute filmbildende Eigenschaften, und die damit hergestellten Kopierschichten zeigen eine bessere Flexibilität als mit den auf Basis Phenol-Formaldehyd hergestellten Novolaken, haben eine härtere Gradation und in vielen Fällen eine gute Beständigkeit gegen Chemikalien und gegen verschiedene ätzmittel.

Es folgen Synthese-Beispiele von Kondensationsprodukten gemäß der Erfindung:

**Synthese 1**

24,8 g 2-Methyl-resorcin werden in 51,6 g 4,4'-Bis-(methoxymethyl)-diphenylether (im Folgenden als MMDPO bezeichnet) in der Wärme gelöst und mit 1 ml Diethylsulfat versetzt. Die Reaktionslösung wird unter gutem Rühren langsam auf 110°C erhitzt. Nach etwa 5 bis 10 Minuten setzt unter meist heftiger Reaktion die Kondensation ein. Das hierbei entstehende Methanol wird mit Hilfe eines absteigenden Kühlers entfernt. Die Viskosität der Reaktionslösung nimmt im Laufe der Kondensation stark zu, und nach etwa 15 Minuten hat sich das Kondensationsprodukt im Reaktionskolben fest abgeschieden. Es hat einen Schmelzbereich von 110 - 150°C (Z).

**Synthese 2**

24,8 g 2-Methyl-resorcin werden in 52 g MMDPO in der Wärme gelöst. Nach dem Abkühlen auf Raumtemperatur wird die Reaktionslösung nach Zugabe von 20 ml konz. Salzsäure 2 - 3 Stunden lang gerührt. Unter leicht exothermer Reaktion erfolgt die Kondensation, wobei die Viskosität stetig zunimmt. Nachdem das Kondensationsprodukt völlig erstarrt ist, wird es zerkleinert, gut mit Wasser gewaschen und im Vakuum (ca. 50 mbar) bei 30 - 40°C getrocknet. Das hellgelbe Reaktionsprodukt hat einen Schmelzbereich von 100 - 140°C (Z).

**Synthese 3**

54,6 g 2-Methyl-resorcin werden in 50 ml Xylol und 103,3 g MMDPO unter leichtem Erwärmen gelöst. Nach Zugabe von 1 ml Methansulfonsäure wird die Lösung langsam unter gutem Rühren auf 110°C erwärmt. Bei etwa 100°C setzt die Kondensation ein unter Abspaltung von Methanol, das mit Hilfe eines absteigenden Kühlers abdestilliert wird. Sobald kein Methanol mehr abdestilliert, wird die Reaktionstemperatur erhöht und die Kondensation bei 135 - 140°C zu Ende geführt. Nach ca. 45 Minuten ist die Kondensation zu Ende, d. h. es destilliert kein Methanol mehr ab, und der Siedepunkt des Destillats gleicht sich der Innentemperatur der Reaktionslösung an. Man kühlt auf etwa 100°C ab und gießt die noch heiße Reaktionslösung in eine Schale, wo sie beim Abkühlen erstarrt. Das gelbbraune Kondensationsprodukt wird fein pulverisiert und zwecks Entfernung von restlichem Xylol zweimal mit Benzin (Siedebereich: 40 - 60°C) unter gutem Rühren gewaschen. Nicht umgesetztes 2-Methyl-resorcin kann leicht durch Digerieren mit Wasser entfernt werden. Das Rohprodukt schmilzt bei 80 - 110°C unter Zersetzung. Zur Reinigung wird es in Aceton gelöst, filtriert und unter gutem Rühren in 3 Liter Wasser langsam eingegossen. Es wird so lange nachgerührt, bis das mitunter als Weichharz ausfallende Kondensationsprodukt fest geworden ist. Das Kondensations produkt hat einen Schmelzbereich von 110 - 140°C (Z).

**Synthese 4**

24,8 g 2,4-Dihydroxy-toluol werden in 52 g MMDPO in der Wärme gelöst. Nach Zugabe von 5 ml Phosphoroxidchlorid wird das Reaktionsgefäß unter leichtem Rühren 24 Stunden bei Raumtemperatur stehengelassen und anschließend unter kräftigem Rühren in 3 Liter Eiswasser eingegossen. Das Kondensationsprodukt fällt hierbei in fester Form mit gelborangener Farbe aus. Es wird säurefrei gewaschen und im Vakuum bei 30 - 40°C getrocknet. Schmelzbereich: 90-110°C.

**Synthese 5**

Das gleiche Kondensationsprodukt wie bei Synthese 4 resultiert, wenn eine Lösung von 24,8 g 2,4-Dihydroxy-toluol und 52 g MMDPO in 50 ml Xylol in Gegenwart von 1 ml Methansulfonsäure als Kondensationsmittel 1 Stunde auf 120°C unter gutem Rühren erhitzt wird. Das hierbei entstehende Methanol wird mit Hilfe eines absteigenden Kühlers abdestilliert. Nach erfolgter Kondensation wird das noch heiße Reaktionsgemisch in eine Schale gegossen und erkalten gelassen. Das erstarrte Kondensationsprodukt wird zerkleinert und zweimal mit Gasolin zwecks Entfernung von restlichem Xylol gründlich gewaschen. Das rotbraune Kondensationsprodukt hat einen Schmelzbereich von 90 - 120°C (Z).

**Synthese 6**

Eine Lösung von 39,6 g Gallussäureethylester und 52 g MMDPO in 50 ml Ethanol wird in Gegenwart von 10 ml konz. Salzsäure 2 Stunden unter Rühren am Sieden gehalten. Anschließend wird nach dem Abkühlen die viskose Reaktionslösung in 3 Liter Eiswasser unter kräftigem Rühren eingegossen. Das Kondensationsprodukt fällt in fester Form aus. Es wird säurefrei gewaschen und im Vakuum bei 30 - 40°C getrocknet. Der Schmelzbereich liegt oberhalb 300°C.

**Synthese 7**

Molare Mengen 4-t-Butylphenol und MMDPO werden in Gegenwart von 0,5 ml Chlorsulfonsäure langsam auf 120°C erwärmt. Unter heftiger Reaktion setzt die Kondensation nach kurzer Zeit unter Abspaltung von

Methanol ein, und die ursprünglich klare Lösung erstarrt zu einem elastischen Kondensationsprodukt. Präparativ sinnvoller wird diese Kondensation wie folgt durchgeführt: 30 g 4-t-Butyl-phenol werden in 52 g MMDPO und 50 ml Xylol gelöst und in Gegenwart von 1 ml Methansulfonsäure unter gutem Rühren auf 115°C erhitzt. Bei 110°C setzt die Kondensation unter Abspaltung von Methanol ein, das mit Hilfe eines absteigenden Kühlers abdestilliert wird. Nach 30 Minuten wird die Reaktionstemperatur auf 140°C erhöht. Sobald kein Methanol mehr abdestilliert, wird das Reaktionsgemisch auf etwa 50°C abgekühlt und unter kräftigem Rühren in 1 Liter Gasolin eingegossen, worin sich das Kondensationsprodukt allmählich in fester Form abscheidet. Schmelzbereich: 80 - 120°C (Z).

**Synthese 8**

Eine Lösung von 30,4 g 2,4-Dihydroxy-acetophenon und 52 g MMDPO wird in Gegenwart von 20 ml konz. Salzsäure 3 Stunden unter Rühren am Sieden gehalten. Anschließend wird die Reaktionslösung in 3 Liter Eiswasser eingerührt, wobei das Kondensationsprodukt als Weichharz ausfällt. Es wird säurefrei gewaschen und im Vakuum bei 30- 40°C entwässert.

**Synthese 9**

Eine Lösung von 36,4 g 2,4-Dihydroxy-benzoesäureethyl-ester, 52 g MMDPO und 100 g Xylol wird mit 1 ml Methansulfonsäure versetzt und langsam unter gutem Rühren auf 115 - 120°C erhitzt. Das bei der Kondensation entstehende Methanol wird mit Hilfe eines absteigenden Kühlers abdestilliert. Nach Beendigung der Methanolabscheidung wird die Reaktionslösung noch kurz auf etwa 138°C erhitzt, bis sich der Siedepunkt des Destillats der Innentemperatur angeglichen hat. Nach dem Erkalten wird die Reaktionslösung in Gasolin eingerührt. Das anfangs viskos ausfallende Kondensationsprodukt wird nach längerem Rühren fest. Zwecks Entfernung von restlichem Xylol wird das getrocknete gelbe Kondensationsprodukt noch zweimal mit Gasolin gewaschen. Schmelzbereich: 110 - 140°C (Z).

**Synthese 10**

Eine Lösung von 27,3 g 2-Methyl-resorcin und 33,2 g Bis-(methoxymethyl)-benzol in 50 ml Xylol wird in Gegenwart von 1 ml Methansulfonsäure unter gutem Rühren langsam auf 125°C erhitzt. Bei etwa 110°C setzt die Kondensation ein unter Abspaltung von Methanol, das mit Hilfe eines absteigenden Kühlers abdestilliert wird. Das rotbraune Kondensationsprodukt beginnt sich aus der Reaktionslösung abzuscheiden. Nach einer Stunde ist die Methanolabscheidung zu Ende. Die Temperatur wird kurz auf 135 - 138°C erhöht, bis Xylol abzudestillieren beginnt. Das Reaktionsgemisch wird abkühlen gelassen, das ausgefallene tief orangefarbene Kondensationsprodukt abgesaugt, mit Gasolin gut gewaschen und nach dem Trocknen zwecks Entfernung von nicht umgesetztem 2-Methyl-resorcin in 1 Liter Wasser gut durchgerührt. Nach dem Trocknen schmilzt das Kondensationsprodukt bei 260°C unter Zersetzung.

**Synthese 11**

6,2 g 2-Methyl-resorcin werden in 40 ml Dioxan gelöst und mit 3 ml Phosphoroxidchlorid versetzt. Hierzu läßt man unter gutem Rühren bei Siedehitze eine Lösung von 13,9 g 4,4'-Bis-(hydroxymethyl)-diphenylsulfon in 60 ml Dioxan zutropfen. Die Reaktionslösung wird 2 Stunden am Sieden gehalten. Nach dem Abkühlen wird die rotbraune Lösung in 1 Liter Gasolin eingerührt, wobei das Kondensationsprodukt zunächst als Weichharz ausfällt. Letzteres wird in Wasser so lange gerührt, bis das Weichharz fest geworden ist. Nach dem Trocknen im Vakuumschrank bei ca. 40°C hat das gelbe Kondensationsprodukt einen Schmelzbereich von 90 - 120°C (Z).

**Synthese 12**

24,8 g 2,4-Dihydroxy-toluol werden in 50 ml Ethanol gelöst, mit 10 ml konz. Salzsäure versetzt und in der Siedehitze, analog wie unter Synthese 10 beschrieben, mit 52 g MMDPO kondensiert. Das gelbe Kondensationsprodukt hat einen Schmelzbereich von 110 - 140°C.

**Synthese 13**

Eine Lösung von 30 g 4-t-Butyl-phenol in 39 g 4,4'-Bis-(methoxymethyl)-benzol (85 %) wird in Gegenwart von 2 ml Methansulfonsäure eine Stunde am Sieden gehalten. Nach beendeter Kondensation wird die auf Raumtemperatur abgekühlte Reaktionslösung in 3 Liter Eiswasser unter kräftigem Rühren eingegossen, wobei das Kondensationsprodukt zunächst als farbloses Weichharz ausfällt, das bei längerem Rühren allmählich fest wird. Schmelzbereich: 70 - 100°C.

**Synthese 14**

18,8 g Phenol werden in 51,6 g MMDPO gelöst und mit 5 ml Phosphoroxidchlorid versetzt. Unter öfterem Schütteln der Reaktionslösung läßt man bei Raumtemperatur die Kondensation ablaufen. Die Lösung erwärmt sich allmählich, und nach etwa 30 Minuten hat sich unter heftiger Reaktion ein höhermolekulares, in organischen Lösungsmitteln unlösliches Kondensationsprodukt gebildet. ähnlich wie Phenol verhalten sich Resorcin und Pyrogallol.

Entsprechend wie MMDPO reagieren mit den angegebenen Phenolen 4,4'-Bis-(methoxymethyl)-benzol, 4,4'-Bis-(methoxymethyl)-diphenyl, 4,4'-Bis-(methoxymethyl)-diphenylmethan und 4,4'-Bis-(methoxymethyl)-diphenylsulfid.

Die Konzentration des Kondensationsprodukts in dem lichtempfindlichen Gemisch kann je nach der Natur des lichtempfindlichen Systems sehr unterschiedlich sein. Im allgemeinen liegt der Anteil zwischen 10 und 95, vorzugsweise zwischen 40 und 80 Gew.-%, bezogen auf das Gemisch der nichtflüchtigen Bestandteile des lichtempfindlichen Gemisches.

Die erfindungsgemäßen lichtempfindlichen Gemische enthalten ferner eine lichtempfindliche Verbindung oder eine lichtempfindliche Kombination von Verbindungen. Geeignet sind vor allem positiv arbeitende Verbindungen, d. h. solche, die durch Belichten löslich werden. Hierzu gehören o-Chinondiazide und Kombinationen von photolytischen Säurespendern und säurespaltbaren Verbindungen, wie Orthocarbonsäure- und Acetalverbindungen. Als lichtempfindliche Verbindungen sind ferner p-Chinondiazide und Diazoniumsalz-Polykondensationsprodukte geeignet.

Das erfindungsgemäße Gemisch und Verfahren haben besondere Vorteile in Verbindung mit lichtempfindlichen Materialien auf Basis von o-Chinondiaziden, da deren Auflage durch Einbrennen eine besonders große Erhöhung erfährt. Geeignete Materialien dieser Art sind bekannt und z. B. in der DE-C 938 233, den DE-A 23 31 377, 25 47 905 und 28 28 037 beschrieben. Als o-Chinondiazide werden bevorzugt Naphthochinon-(1,2)-diazid-(2)-4- oder 5-sulfon-säureester oder -amide verwendet. Von diesen werden die Ester, insbesondere die der 5-Sulfonsäure, besonders bevorzugt. Die Menge an o-Chinondiazidverbindungen beträgt im allgemeinen 3 bis 50, bevorzugt 7 bis 35 Gew.-%, bezogen auf die nichtflüchtigen Anteile des Gemischs.

Auch Materialien auf Basis säurespaltbarer Verbindungen lassen sich mit gutem Effekt einbrennen und bei dem erfindungsgemäßen Verfahren einsetzen.

Kopiermaterialien dieser Art sind bekannt und z. B. in den US-A 3 779 778 und 4 101 323, der DE-C 27 18 254 und den DE-A 28 29 512 und 28 29 511 beschrieben. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine oder 2-Trichlormethyl-1,3,4-oxadiazole.

Von den in der US-A 4 101 323 beschriebenen Orthocarbonsäurederivaten werden besonders die Bis-1,3-dioxan-2-yl-ether von aliphatischen Diolen verwendet.

Von den in der DE-C 27 18 254 beschriebenen Polyacetalen werden diejenigen mit aliphatischen Aldehyd- und Dioleinheiten bevorzugt.

Weitere gut geeignete Gemische sind in der DE-A 29 28 636 beschrieben. Dort werden als säurespaltbare Verbindungen polymere Orthoester mit wiederkehrenden Orthoestergruppen in der Hauptkette beschrieben.

Diese Gruppen sind 2-Alkylether von 1,3-Dioxa-cyclo-alkanen mit 5 oder 6 Ringgliedern. Besonders bevorzugt werden Polymere mit wiederkehrenden 1,3-Dioxa-cyclohex-2-yl-alkylethereinheiten, in denen die Alkylethergruppe durch Ethersauerstoffatome unterbrochen sein kann und bevorzugt an die 5-Stellung des benachbarten Rings gebunden ist.

Der Mengenanteil der säurespaltbaren Verbindungen in dem lichtempfindlichen Gemisch liegt im allgemeinen zwischen 8 und 65, vorzugsweise zwischen 14 und 44 Gew.-%, bezogen auf die nichtflüchtigen Bestandteile des Gemischs. Die Menge der Säure abspaltenden Verbindung liegt zwischen 0,1 und 10, vorzugsweise zwischen 0,2 und 5 Gew.-%.

In den erfindungsgemäßen Gemischen können zusätzlich zu den vorstehend beschriebenen Phenolkondensationsprodukten noch zahlreiche andere Harze mitverwendet werden, bevorzugt Vinylpolymerisate wie Polyvinylacetate, Polyacrylate, Polyvinylether, Polyvinylacetale, Polyvinylpyrrolidone und die Mischpolymerisate der ihnen zugrundeliegenden Monomeren.

Als weitere alkalilösliche bzw. in Alkali quellbare Bindemittel sind natürliche Harze wie Schellack und

Kolophonium und synthetische Harze wie Mischpolymerisate aus Styrol und Maleinsäureanhydrid oder Mischpolymerisate der Acrylsäure oder Methacrylsäure, insbesondere mit Acryl- oder Methacrylsäureestern, sowie Novolake zu nennen. Der günstigste Anteil an diesen Harzen richtet sich nach den anwendungstechnischen Erfordernissen und dem Einfluß auf die Entwicklungsbedingungen. In geringen Mengen kann das lichtempfindliche Gemisch für spezielle Erfordernisse wie Flexibilität, Haftung, Glanz, Färbung und Farbumschlag etc. außerdem noch Substanzen wie Polyglykole, Cellulose-Derivate wie Ethylcellulose, Netzmittel, Farbstoffe, Haftvermittler und feinteilige Pigmente sowie bei Bedarf UV-Absorber enthalten.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykol-monoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Als Schichtträger für Schichtdicken unter ca. 10µm werden meist Metalle verwendet. Für Offsetdruckplatten können eingesetzt werden: walzblankes, mechanisch oder elektrochemisch aufgerauhtes und ggf. anodisiertes Aluminium, das zudem noch chemisch, z. B. mit Polyvinylphosphonsäure, Silikaten, Hexafluorozirkonaten, hydrolysiertem Tetraethylorthosilikat oder Phosphaten, vorbehandelt sein kann.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag.

Belichtet wird mit den in der Technik üblichen Lichtquellen. Auch das Bestrahlen mit Elektronen oder Laser stellt eine Möglichkeit zur Bebilderung dar.

Die zum Entwickeln verwendeten wäßrig-alkalischen Lösungen abgestufter Alkalität, d. h. mit einem pH, das bevorzugt zwischen 10 und 14 liegt, und die auch kleinere Mengen organischer Lösungs- oder Netzmittel enthalten können, entfernen die vom Licht getroffenen Stellen der Kopierschicht und erzeugen so ein positives Abbild der Vorlage. Negativschichten können mit ähnlichen Entwicklern verarbeitet werden.

Bevorzugte Anwendung finden die erfindungsgemäßen lichtempfindlichen Gemische bei der Herstellung von Druckformen, insbesondere Offsetdruckformen, mit Aluminium als Schichtträger. Die erfindungsgemäßen lichtempfindlichen Gemische lassen sich auch vorteilhaft als Photoresistmaterialien, z. B. zur Herstellung von gedruckten Schaltungen und integrierten Schaltkreisen, sowie für ähnliche Zwecke verwenden.

Nach dem Entwickeln kann die Druckform in an sich bekannter Weise erhitzt werden. Die Einbrenntemperaturen können im Bereich von etwa 180 bis 240°C, gewählt werden, wobei normalerweise Erhitzungszeiten von 1 - 20, bevorzugt 5 bis 10 Minuten, erforderlich sind. Wenn das Trägermaterial gegen höhere Temperaturen beständig ist, ist es selbstverständlich auch möglich, bei höheren Temperaturen oberhalb 240°C einzubrennen und dementsprechend kürzere Erhitzungszeiten zu wählen.

Das erfindungsgemäße Gemisch und das daraus hergestellte lichtempfindliche Kopiermaterial zeichnen sich dadurch aus, daß beim Einbrennen der fertig entwickelten Druckform praktisch keine Einbrennrückstände auf den bildfreien Bereichen des Trägers hinterbleiben.

Das zusätzliche Aufbringen einer wasserlöslichen Schutzschicht vor dem Einbrennen oder das nachträgliche Entfernen der Rückstände durch Behandeln mit Entwickler können deshalb entfallen. Dieser Vorteil wird mit Phenol- oder Kresol-Formaldehyd-Kondensationsprodukten als Bindemittel in einem lichtempfindlichen Gemisch nicht erreicht.

Die Erfindung wird anhand der nachfolgenden Beispiele näher erläutert, in denen Gewichtsteile (Gt) und Volumteile (Vt) im Verhältnis von g zu ccm stehen. Prozente sind, wenn nichts anderes angegeben ist, Gewichtsprozente.

**Beispiel 1**

Mit einer Lösung von

2,00 Gt des Veresterungsproduktes aus 1 mol 2,3,4-Trihydroxy-benzophenon und 3 mol Naphthochinon-(1,2)-diazid-(2)-5-sulfon-säurechlorid,

4,00 Gt des Kondensationsprodukts nach Synthese 3,

0,20 Gt Naphthochinon-(1,2)-diazid-(2)-4-sulfon-säurechlorid und

0,12 Gt Kristallviolett in

40 Gt Ethylenglykolmonomethylether und

60 Gt Tetrahydrofuran

wurde eine elektrochemisch aufgerauhte und anodisierte Aluminiumplatte beschichtet. Der anodisierte Träger war vor dem Aufbringen der lichtempfindlichen Kopierschicht mit einer wäßrigen Lösung von 0,1 Gew.-% Polyvinylphosphonsäure behandelt worden.

Das so hergestellte vorsensibilisierte Material mit einem Schichtgewicht von ca. 2,0 g/m$^2$ wurde unter einer

transparenten Positiv-Vorlage bildmäßig belichtet und anschliessend mit einer 10%igen wäßrigen Lösung von Natriummetasilikat x 9 Wasser entwickelt.

Durch die Entwicklung wurden die vom Licht getroffenen Anteile der Kopierschicht entfernt, und es blieben die unbelichteten Bildstellen auf dem Schichtträger zurück, wobei man die der Vorlage entsprechende Druckschablone erhielt. Von der so hergestellten Druckform konnten in einer Offsetdruckmaschine 150.000 einwandfreie Drucke hergestellt werden.

Die Druckschablone zeichnete sich durch eine ausgezeichnete Entwicklerresistenz und gute Haftung auf dem Träger aus. Bemerkenswert gut war ferner die Resistenz der Kopierschicht gegenüber Chemikalien, z. B. gegen alkoholhaltige saure Feuchtwässer oder benzinhaltige Auswaschmittel, wie sie üblicherweise während des Druckvorganges an den Druckmaschinen verwendet werden. Hervorzuheben ist ferner die mit der Kopierschicht erzielte relativ steile Gradation, die in der drucktechnischen Praxis bekanntlich gewünscht wird, weil sie kopiertechnische Vorteile bringt.

Ersetzt man das Bindemittel im Beispiel 1 durch einen Phenol-Formaldehyd-Novolak oder durch das Kondensationsprodukt aus 2-Methylresorcin und Formaldehyd, so erhält man nach dem Beschichten einer elektrochemisch aufgerauhten und anodisierten Aluminiumplatte und weiterer Verarbeitung entsprechend Beispiel 1 eine Druckschablone, die eine vergleichsweise wesentlich geringere Chemikalien- und Entwicklerresistenz und niedrigere Druckauflage aufweist.

Zwecks Erhöhung der Druckauflage und Verfestigung der Druckschablone wurde die Druckform einer Wärmebehandlung unterzogen. Zu diesem Zweck wurde die getrocknete Druckform nach dem Entwickeln in einem Einbrennofen 5 Minuten auf 220° C erhitzt.

Durch das Erhitzen der Druckform im Ofen trat eine Verfestigung der Druckschablone ein, und die Schicht wurde resistent gegenüber Chemikalien, z. B. Korrekturmitteln, und damit unlöslich in organischen Lösungsmitteln, wie Aceton, Alkoholen, Toluol oder Xylol. Nach dem Erhitzen wurde die Druckform ohne weitere Behandlung mit Druckfarbe in Gegenwart von Wasser eingefärbt. In einer Offsetdruckmaschine wurden 250.000 einwandfreie Kopien erhalten.

Ersetzt man im Beispiel 1 das Bindemittel aus 2-Methyl-resorcin und MMDPO durch die gleiche Menge eines Phenoloder Kresol-Formaldehyd-Novolaks und brennt dann die entsprechend hergestellten Druckformen ein, so resultiert beim Einfärben mit fetter Farbe starker Ton an den bildfreien Stellen, der nicht mehr zu entfernen ist. Diese Tonerscheinungen haben ihre Ursache darin, daß Einbrennrückstände von der Schicht sich auf die bildfreien Stellen absetzen. Zur Vermeidung dieser Tonerscheinungen ist es daher erforderlich, vor dem Einbrennen eine Schutzschicht auf die kopierte Druckplatte zu bringen, die nach dem Einbrennvorgang wieder entfernt werden muß. Dieser zusätzliche Arbeitsschritt ist bei Einsatz der erfindungsgemäß beschriebenen Bindemittel nicht erforderlich.

Die gleichen guten kopier- und drucktechnischen Ergebnisse, wie sie hier beschrieben wurden, werden erhalten, wenn im Beispiel 1 das Bindemittel nach Synthese 3 gegen das entsprechende Bindemittel nach Synthese 1 oder 2 ausgetauscht wird.

In den folgenden Beispielen werden weitere Beschichtungslösungen angegeben, wobei ähnliche Ergebnisse erhalten wurden. Wenn nicht gesondert vermerkt, entsprechen Herstellung und Verarbeitung der damit erhaltenen Druckplatten den in Beispiel 1 beschriebenen Bedingungen.

**Beispiel 2**

Mit einer Lösung von

2,00 Gt des Veresterungsproduktes aus 1 mol 2,3,4-Trihydroxy-benzophenon und 3 mol Naphthochinon-(1,2)-diazid-(2)-5-sulfon-säurechlorid,

0,20 Gt Naphthochinon-(1,2)-diazid-(2)-4-sulfon-säurechlorid,

3,00 Gt des Kondensationsprodukts nach Synthese 7,

3,00 Gt eines Phenol-Formaldehyd-Novolaks mit 14 % phenolischen OH-Gruppen und einem Erweichungspunkt von 110-120° C und

0,12 Gt Kristallviolett in

40,00 Gt Ethylenglykolmonomethylether und

60,00 Gt Tetrahydrofuran

wurde eine elektrolytisch aufgerauhte und anodisierte Aluminiumplatte beschichtet. Der anodisierte Aluminiumträger war vor dem Aufbringen der lichtempfindlichen Kopierschicht mit einer wäßrigen Lösung von Polyvinylphosphonsäure behandelt worden, wie es in der DE-C 16 21 478 beschrieben ist.

**Beispiel 3**

Mit einer Lösung von

2,0 Gt des Veresterungsproduktes aus 1 mol 2,3,4-Trihydroxy-benzophenon und 3 mol Naphthochinon-(1,2)-diazid-(2)-5-sulfon-säurechlorid, 6,0 Gt des Kondensationsprodukts nach Synthese 6,

0,2 Gt Naphthochinon-(1,2)-diazid-(2)-4-sulfon-säurechlorid und
0,12 Gt Kristallviolett in
40,00 Gt Ethylenglykolmonomethylether und
60,00 Gt Tetrahydrofuran
wurde eine wie in Beispiel 1 behandelte Aluminiumplatte beschichtet. Die so hergestellte lichtempfindliche Druckplatte wurde unter einer transparenten Positiv-Vorlage bildmäßig belichtet und mit der im Beispiel 1 angegebenen Lösung entwickelt.

**Beispiel 4**

Mit einer Lösung von
2,00 Gt des Veresterungsproduktes aus 1 mol 2,3,4-Trihydroxy-benzophenon und 3 mol Naphthochinon-(1,2)-diazid-(2)-5-sulfon-säurechlorid,
4,00 Gt des Kondensationsprodukts nach Synthese 8,
0,20 Gt Naphthochinon-(1,2)-diazid-(2)-4-sulfonsäure-chlorid und
0,12 Gt Kristallviolett in
40,00 Gt Ethylenglykolmonomethylether und
60,00 Gt Tetrahydrofuran
wurde eine wie in Beispiel 1 behandelte Aluminiumplatte beschichtet. Die so hergestellte lichtempfindliche Druckplatte wurde unter einer transparenten Positiv-Vorlage bildmäßig belichtet und mit der im Beispiel 1 angegebenen Lösung entwickelt.

**Beispiel 5**

Mit einer Lösung von
2,00 Gt des Veresterungsproduktes aus 1 mol 2,3,4-Trihydroxy-benzophenon und 3 mol Naphthochinon-(1,2)-diazid-(2)-5-sulfon-säurechlorid,
4,00 Gt des Kondensationsprodukts nach Synthese 10,
0,30 Gt 4-(p-Tolylmercapto)-2,5-diethoxy-benzol-diazoniumhexafluorophosphat und
0,12 Gt Kristallviolett in
40,00 Gt Ethylenglykolmonomethylether und
50,00 Gt Tetrahydrofuran.
wurde eine wie in Beispiel 1 vorbehandelte Aluminiumplatte beschichtet. Die so hergestellte lichtempfindliche Druckplatte wurde unter einer transparenten Positiv-Vorlage bildmäßig belichtet und mit der im Beispiel 1 angegebenen Lösung entwickelt.

**Beispiel 6**

Mit einer Lösung von
2,00 Gt des Veresterungsproduktes aus 1 mol 2,3,4-Trihydroxy-benzophenon und 3 mol Naphthochinon-(1,2)-diazid-(2)-5-sulfon-säurechlorid, 0,20 Gt Naphthochinon-(1,2)-diazid-(2)-4-sulfon-säurechlorid,
3,00 Gt des Kondensationsprodukts nach Synthese 5,
3,00 Gt eines Phenol-Formaldehyd-Novolaks mit 14 % phenolischen OH-Gruppen und einem EErweichungspunkt von 110-120° C und
0,12 Gt Kristallviolett in
40,00 Gt Ethylenglykolmonomethylether und
60,00 Gt Tetrahydrofuran
wurde eine elektrolytisch aufgerauhte und anodisierte Aluminiumplatte beschichtet. Der anodisierte Aluminiumträger war vor dem Aufbringen der lichtempfindlichen Kopierschicht mit einer wäßrigen Lösung von Polyvinylphosphonsäure behandelt worden, wie es in der DE-C 16 21 478 beschrieben ist.

**Beispiel 7**

Mit einer Lösung von
2,40 Gt einer 50 %igen Lösung eines Polyorthoesters in Toluol, hergestellt aus 7,7-Bis-hydroxy-methyl-5-oxa-nonanol-(1) und Orthoameisensäuretrimethylester,
0,20 Gt 2,4-Bis-(trichlormethyl)-6-(4-ethoxy-naphth-1-yl)-s-triazin,

5,00 Gt des Kondensationsprodukts nach Synthese 2 und
0,035 Gt Kristallviolett-Base in
30,00 Gt Ethylenglykolmonomethylether und
40,00 Gt Tetrahydrofuran
wurde eine wie in Beispiel 1 vorbehandelte Aluminiumplatte beschichtet. Die so hergestellte Druckplatte wurde 15 Sekunden unter einer 5 kW-Metallhalogenidlampe im Abstand von 110 cm bildmäßig belichtet und anschliessend mit einer 6%igen wäßrigen Natriummetasilikatlösung entwickelt.

**Beispiel 8**

Mit einer Lösung von
0,55 Gt eines Polyacetals, hergestellt aus Triethylenglykol und 2-Ethyl-butyraldehyd,
0,10 Gt 2-(4-Ethoxy-naphth-1-yl)-4,6-bis-trichlor-methyl-s-triazin,
2,50 Gt des Kondensationsproduktes nach Synthese 2 und
0,016 Gt Kristallviolett-Base in
20,00 Gt Ethylenglykolmonomethylether und
20,00 Gt Tetrahydrofuran
wurde eine elektrochemisch aufgerauhte und anodisierte Aluminiumplatte beschichtet.

Die so hergestellte Druckplatte wurde 15 Sekunden unter einer 5 kW-Metallhalogenidlampe im Abstand von 110 cm bildmäßig belichtet und anschließend mit einer 8%igen wäßrigen Natriummetasilikatlösung entwickelt.

**Beispiel 9**

Mit einer Lösung von
2,00 Gt des Veresterungsproduktes aus 1 mol 2,3,4-Trihydroxy-benzophenon und 3 mol Naphthochinon-(1,2)-diazid-(2)-5-sulfon-säurechlorid,
0,20 Gt Naphthochinon-(1,2)-diazid-(2)-4-sulfon-säurechlorid,
3,00 Gt des Kondensationsprodukts nach Synthese 13,
1,00 Gt eines Phenol-Formaldehyd-Novolaks mit 14 % phenolischen OH-Gruppen und einem Erweichungspunkt von 110-120° C und
0,12 Gt Kristallviolett in
40,00 Gt Ethylenglykolmonomethylether und
60,00 Gt Tetrahydrofuran
wurde eine elektrolytisch aufgerauhte und anodisierte Aluminiumplatte beschichtet. Der anodisierte Aluminiumträger war vor dem Aufbringen der lichtempfindlichen Kopierschicht mit einer wäßrigen Lösung von Polyvinylphosphonsäure behandelt worden, wie es in der DE-C 16 21 478 beschrieben ist.

**Beispiel 10**

Mit einer Lösung von
2,00 Gt des Veresterungsproduktes aus 1 mol 4-(2-Phenyl-prop-2-yl)phenol und 1 mol Naphthochinon-(1,2)-diazid-(2)-4-sulfon-säurechlorid,
0,20 Gt Naphthochinon-(1,2)-diazid-(2)-4-sulfon-säurechlorid,
4,00 Gt des Kondensationsprodukts nach Synthese 11,
0,12 Gt Kristallviolett in
40,00 Gt Ethylenglykolmonomethylether und
60,00 Gt Tetrahydrofuran
wurde eine elektrolytisch aufgerauhte und anodisierte Aluminiumplatte beschichtet. Der anodisierte Aluminiumträger war vor dem Aufbringen der lichtempfindlichen Kopierschicht mit einer wäßrigen Lösung von Polyvinylphosphonsäure behandelt worden, wie es in der DE-C 16 21 478 beschrieben ist.

**Patentansprüche**

1. Lichtempfindliches Gemisch, das bei Belichtung seine Löslichkeit in einer wäßrig-alkalischen Lösung ändert und das eine lichtempfindliche Verbindung oder eine lichtempfindliche Kombination von Verbindungen und ein wasserunlösliches, in wäßrig-alkalischen Lösungen lösliches Bindemittel enthält, dadurch gekennzeichnet, daß das Bindemittel ein Polykondensationsprodukt aus einem Phenol der allgemeinen Formel

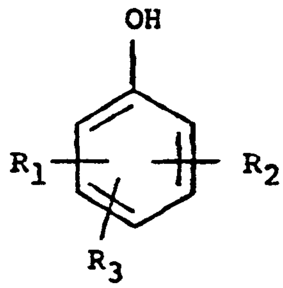

worin
$R_1$ ein Wasserstoffatom, eine Alkyl- oder Hydroxygruppe,
$R_2$ ein Wasserstoffatom, eine Alkyl-, Hydroxy- oder Acetylgruppe und
$R_3$ ein Wasserstoff- oder Halogenatom, eine Alkyl-, Alkoxy-, Carboxyl- oder Carbonsäureestergruppe ist,
und einer Verbindung der allgemeinen Formel
$ROCH_2 - X - CH_2OR$
ist, worin
R ein Wasserstoffatom, ein Methyl-, Ethyl- oder Acetylrest und
X eine Phenylengruppe oder eine zweiwertige aromatische Gruppe ist, die aus zwei durch eine Einfachbindung, eine Ether-, Sulfid-, Sulfon- oder Alkylengruppe verbundenen Phenylengruppen besteht, und gegebenenfalls substituiert sein kann.

2. Lichtempfindliches Gemisch nach Anspruch 1, dadurch gekennzeichnet, daß das Polykondensationsprodukt mindestens drei Einheiten der phenolischen Verbindung enthält.

3. Lichtempfindliches Gemisch nach Anspruch 1, dadurch gekennzeichnet, daß X eine Gruppe der Formel

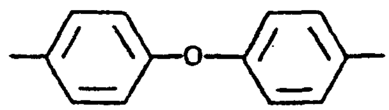

ist.

4. Lichtempfindliches Gemisch nach Anspruch 1 oder 3, dadurch gekennzeichnet, daß R eine Methylgruppe ist.

5. Lichtempfindliches Gemisch nach Anspruch 1, dadurch gekennzeichnet, daß der Mengenanteil des Polykondensationsprodukts 10 bis 95 Gew.-% beträgt.

6. Lichtempfindliches Gemisch nach Anspruch 1, dadurch gekennzeichnet, daß es als lichtempfindliche Verbindung ein 1,2-Chinondiazid enthält.

7. Lichtempfindliches Gemisch nach Anspruch 1, dadurch gekennzeichnet, daß es als lichtempfindliche Kombination von Verbindungen eine Verbindung mit mindestens einer durch Säure spaltbaren C-O-C-Bindung und eine Verbindung enthält, die unter Belichtung eine starke Säure abspaltet.

8. Lichtempfindliches Kopiermaterial, bestehend aus einem Schichtträger und einer lichtempfindlichen Schicht, die eine lichtempfindliche Verbindung oder eine lichtempfindliche Kombination von Verbindungen und ein wasserunlösliches, in wäßrig-alkalischen Lösungen lösliches Bindemittel enthält, dadurch gekennzeichnet, daß das Bindemittel ein Polykondensationsprodukt aus einem Phenol der allgemeinen Formel

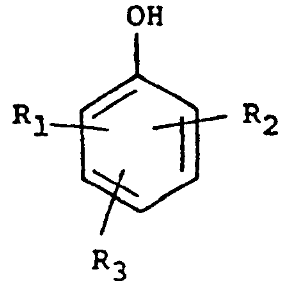

worin
$R_1$ ein Wasserstoffatom, eine Alkyl- oder Hydroxygruppe,
$R_2$ ein Wasserstoffatom, eine Alkyl-, Hydroxy- oder Acetylgruppe und $R_3$ ein Wasserstoff- oder Halogenatom, eine AJkyl-, Alkoxy-, Carboxyl- oder Carbonsäureestergruppe ist,
und einer Verbindung der allgemeinen Formel
$ROCH_2 - X - CH_2OR$
ist, worin

R ein Wasserstoffatom, ein Methyl-, Ethyl- oder Acetylrest und

X eine Phenylengruppe oder eine zweiwertige aromatische Gruppe ist, die aus zwei durch eine Einfachbindung, eine Ether-, Sulfid-, Sulfon- oder Alkylengruppe verbundenen Phenylengruppen besteht, und gegebenenfalls substituiert sein kann.

**Claims**

1. Light-sensitive mixture which undergoes a change of solubility in an aqueous-alkaline solution upon exposure to light and which contains a light-sensitive compound or a light-sensitive combination of compounds and a binder which is insoluble in water and soluble in aqueousalkaline solutions, wherein the binder comprises a polycondensation product of a phenol corresponding to the general formula

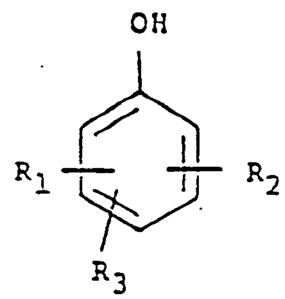

,

in which

$R_1$ is a hydrogen atom, an alkyl group or a hydroxy group,

$R_2$ is a hydrogen atom, an alkyl group, a hydroxy group or an acetyl group, and

$R_3$ is a hydrogen atom or a halogen atom, an alkyl group, an alkoxy group, a carboxyl group or a carboxylic acid ester group, and a compound corresponding to the general formula

$ROCH_2\text{-}X\text{-}CH_2OR$,

in which

R is a hydrogen atom, a methyl group, an ethyl group or an acetyl group and

X is a phenylene group or a divalent aromatic group which comprises two phenylene groups linked by a single bond, an ether group, a sulfide group, a sulfone group, or an alkylene group and which may be unsubstituted or substituted.

2. A light-sensitive mixture as claimed in claim 1, wherein the polycondensation product comprises at least three units of the phenolic compound.

3. A light-sensitive mixture as claimed in claim 1, wherein X is a group corresponding to the formula

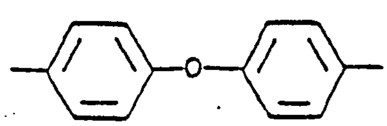

4. A light-sensitive mixture as claimed in claim 1 or claim 3, wherein R is a methyl group.

5. A light-sensitive mixture as claimed in claim 1, wherein the quantitative proportion of the polycondensation product ranges from 10 to 95 % by weight.

6. A light-sensitive mixture as claimed in claim 1, which contains a 1,2-quinone diazide as the light-sensitive compound.

7. A light-sensitive mixture as claimed in claim 1, which contains a compound having at least one C-O-C bond which can be split by acid and a compound which eliminates a strong acid upon exposure, as the light-sensitive combination of compounds.

8. Light-sensitive copying material comprising a support and a light-sensitive layer which is composed of a light-sensitive compound or a light-sensitive combination of compounds and a binder which is insoluble in water and soluble in aqueous-alkaline solutions, wherein the binder comprises a polycondensation product of a phenol corresponding to the general formula

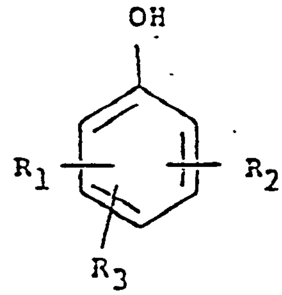 ,

in which

$R_1$ is a hydrogen atom an alkyl group or a hydroxy group,

$R_2$ is a hydrogen atom, an alkyl group, a hydroxy group or an acetyl group, and

$R_3$ is a hydrogen atom or a halogen atom, an alkyl group, an alkoxy group, a carboxyl group or a carboxylic acid ester group,

and a compound corresponding to the general formula

$ROCH_2$-X-$CH_2OR$,

in which

R is a hydrogen atom, a methyl group, an ethyl group or an acetyl group and

X is a phenylene group or a divalent aromatic group which comprises two phenylene groups linked by a single bond, an ether group, a sulfide group, a sulfone group or an alkylene group and which may be unsubstituted or substituted.

**Revendications**

1. Mélange photosensible, dont la solubilité dans une solution aqueuse-alcaline est modifiée lors de l'exposition à la lumière et qui contient un composé photosensible ou une combinaison photosensible de composés et un liant insoluble dans l'eau, soluble dans les solutions aqueuses-alcalines, caractérisé en ce que le liant est un produit de polycondensation d'un phénol répondant à la formule générale

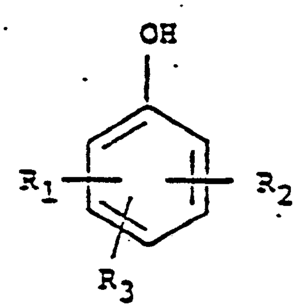

dans laquelle

$R_1$ désigne un atome d'hydrogène, un groupe alkyle ou hydroxyle,

$R_2$ désigne un atome d'hydrogène, un groupe alkyle, hydroxy ou acétyle et

$R_3$ désigne un atome d'hydrogène ou d'halogène, un groupe alkyle, alcoxy, carboxyle ou ester d'acide carboxylique,

et d'un composé répondant à la formule générale

$ROCH_2$ - X - $CH_2OR$

dans laquelle

R est un atome d'hydrogène, un radical méthyle, éthyle ou acétyle et

X est un groupe phénylène ou un groupe aromatique bivalent qui se compose de deux groupes phénylène liés par une simple liaison, un groupe éther, sulfure, sulfone ou alkylène, et peut le cas échéant être substitué.

2. Mélange photosensible selon la revendication 1, caractérisé en ce que le produit de polycondensation contient au moins trois motifs de composé phénolique.

3. Mélange photosensible selon la revendication caractérisé en ce que X est un groupe répondant à formule

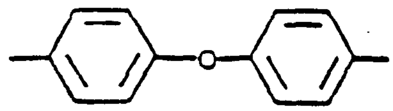

4. Mélange photosensible selon les revendications 1 ou 3, caractérisé en ce que R est un groupe méthyle.

5. Mélange photosensible selon la revendication 1, caractèrisé en ce que la proportion pondérale du produit de polycondensation est de 10 à 95 % en poids.

6. Mélange photosensible suivant la revendication 1, caractérisé en ce qu'il contient, comme composé photosensible, un 1,2-quinonediazide.

7. Mélange photosensible suivant la revendication 1, caractérisé en ce qu'il contient, comme combinaison de composés photosensibles, un composé ayant au moins une liaison C-O-C pouvant être coupée par un acide et un composé qui libère un acide fort par exposition à la lumière.

8. Matériau de reproduction photosensible, constitué d'un support de couche et d'une couche photosensible qui contient un composé photosensible ou une combinaison photosensible de composés et un liant insoluble dans l'eau, soluble dans les solutions aqueusesalcalines, caractérisé en ce que le liant est un produit de polycondensation d'un phénol répondant à la formule générale

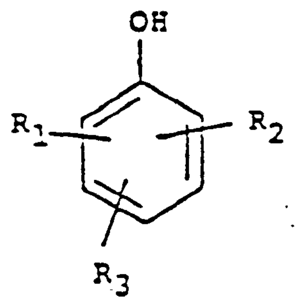

dans laquelle

$R_1$ désigne un atome d'hydrogène, un groupe alkyle ou hydroxy,

$R_2$ désigne un atome d'hydrogène, un groupe alkyle, hydroxy ou acétyle et

$R_3$ désigne un atome d'hydrogène ou d'halogène, un groupe alkyle, alcoxy, carboxyle ou ester d'acide carboxylique,

et d'un composé répondant à la formule générale

$ROCH_2 - X - CH_2OR$

dans laquelle

R est un atome d'hydrogène, un groupe méthyle, éthyle ou acétyle, et

X est un groupe phénylène ou un groupe aromatique divalent qui se compose de deux groupes phénylène liés par une liaison simple, un groupe éther, sulfure, sulfone ou alkylène, et peut le cas échéant être substitué.